# EUROPEAN PATENT APPLICATION

(11) **EP 4 787 356 A1**
(43) Date of publication of application: **05.08.2026**
(21) Application number: 25783013.3
(22) Date of filing: 02.04.2025
(51) Int. Cl.: G09G 3/00, G09G 5/00, G09G 3/32, G06F 3/01

(54) **APPARATUS AND METHOD FOR SUPPORTING MOVEMENT OF IMAGE DATA IN DISPLAY**

(30) Priority: 03.04.2024 KR 20240045198; 03.05.2024 KR 20240059083; 07.10.2024 KR 20240135773
(71) Applicant: Sapien Semiconductors Inc., Seongnam-si, Gyeonggi-do 13449 (KR)
(72) Inventor: JANG, Jin Woong, Seongnam-si Gyeonggi-do 13449 (KR); LEE, Jihaeng, Seongnam-si Gyeonggi-do 13449 (KR)
(74) Representative: dompatent
(86) International application number: PCT/KR2025/004356
(87) International publication number: WO 2025/211754

(57) **Abstract**

Disclosed are a device and a method for supporting image data movement within a display. The display apparatus may include a controller configured to control data writing, driving of a light-emitting element, and data movement, and a plurality of pixels each including a pixel-embedded memory configured to store image data represented by a multi-bit value. Each of the plurality of pixels may be configured to store image data in the pixel-embedded memory during a data write time interval and shift the image data stored in the pixel-embedded memory to one of upper, lower, left, or right adjacent pixels based on a control signal input from the controller during a data movement time interval.

## Description

### [Technical Field]

The present invention relates to digital display systems, and more particularly, to a device and method for supporting image data shifting within a display.

### [Background Art]

A display apparatus may include a plurality of display pixels. The display pixels may be arranged in M×N rows and columns. Each display pixel may include one or more light-emitting elements and is generally composed of three light-emitting elements (R, G, and B), which may be referred to as sub-pixels.

Display apparatus may be applied to a wide range of fields, from small mobile devices to large outdoor display systems. In particular, displays are increasingly utilized in various applications such as automotive devices, augmented reality (AR) devices, and virtual reality (VR) devices.

Accordingly, there remains a need for improvements in various aspects, including display area, form factor, high resolution, processing time, manufacturing cost, reliability, and response speed.

In addition, driving circuit control that considers the power consumption of the display apparatus may be required, and depending on the application to be presented, a method for supporting image data shifting within the display may also be necessary.

### [Disclosure]

### [Technical Problem]

An object of the present invention is to provide a digital display system capable of supporting image data shifting within a display through various embodiments.

### [Technical Solution]

According to one embodiment of the present invention, a display apparatus may include a controller configured to control data writing, light-emitting element driving, and data movement, and a plurality of pixels each including a pixel-embedded memory configured to store image data represented by a multi-bit value. Each of the plurality of pixels is configured to store the image data in the pixel-embedded memory during a data write time interval and to shift the image data stored in the pixel-embedded memory to one of upper, lower, left, or right adjacent pixels based on a control signal input from the controller during a data movement time interval.

The pixel-embedded memory may include a first dummy shift register configured to retrieve 1-bit data stored in a pixel-embedded memory of an adjacent pixel, n-bit shift registers configured to store n-bit image data, and a second dummy shift register configured to retrieve 1-bit data stored in the n-bit shift registers.

The first dummy shift register may operate to retrieve 1-bit data from the pixel-embedded memory of the adjacent pixel at a first clock of the data movement time interval. The second dummy shift register may operate to retrieve 1-bit data from the n-bit shift registers at a second clock of the data movement time interval. Each of the n-bit shift registers may be configured to shift 1-bit data starting from a third clock of the data movement time interval.

The first dummy shift register and the second dummy shift register may include a reset switch configured to reset the registers after the image data is moved.

In this case, image data shift between left and right adjacent pixels connected to the same column line may be performed over n+1 line times.

Also, image data shift between upper and lower adjacent pixels may include image data shift from a first pixel of a first column line to a second pixel of a second column line. The first pixel may perform bit-wise shifting in the order of its first dummy shift register, second dummy shift register, and n-bit shift registers during a clock cycle of the first column line, and the second pixel may perform bit-wise shifting in the same order during a clock cycle of the second line that is delayed by one line time relative to the clock cycle of the first column line.

A method of supporting data movement in a display apparatus according to one embodiment of the present invention may include: storing image data represented by a multi-bit value in a pixel-embedded memory of each of a plurality of pixels during a data write time interval; receiving a control signal for controlling data movement during a data movement time interval; and shifting the image data stored in the pixel-embedded memory to one of upper, lower, left, or right adjacent pixels based on the control signal.

A pixel of a display apparatus according to one embodiment of the present invention may include a light-emitting element and a pixel circuit connected to the light-emitting element. The pixel circuit may include a path controller configured to select a connection path with an adjacent pixel based on a control signal input from a controller, and a pixel-embedded memory configured to store image data represented by a multi-bit value during a data write time interval and to shift the image data through the connection path with the adjacent pixel during a data movement time interval.

The path controller may include a first path controller configured to select a reception path of the image data based on the type of the control signal, and a second path controller configured to select an output path of the image data based on the type of the control signal.

The type of the control signal may include an up control signal (M_UP) for shifting the image data to an upper adjacent pixel, a down control signal (M_DN) for shifting the image data to a lower adjacent pixel, a left control signal (M_LE) for shifting the image data to a left adjacent pixel, and a right control signal (M_RI) for shifting the image data to a right adjacent pixel.

The first path controller may be configured to select a connection path with a lower adjacent pixel for receiving data when the up control signal (M_UP) is received, a connection path with an upper adjacent pixel when the down control signal (M_DN) is received, a connection path with a right adjacent pixel when the left control signal (M_LE) is received, and a connection path with a left adjacent pixel when the right control signal (M_RI) is received.

The second path controller may be configured to select a connection path with an upper adjacent pixel for shifting data when the up control signal (M_UP) is received, a connection path with a lower adjacent pixel when the down control signal (M_DN) is received, a connection path with a left adjacent pixel when the left control signal (M_LE) is received, and a connection path with a right adjacent pixel when the right control signal (M_RI) is received.

According to another embodiment of the present invention, a display apparatus may include a controller configured to control data writing, light-emitting element driving, and data movement, and a plurality of pixels each including a pixel-embedded memory configured to store image data represented by a multi-bit value. At least one of the plurality of pixels may include a plurality of output pins configured to output image data stored in the pixel-embedded memory to an adjacent pixel based on a control signal input from the controller during a data movement time interval, and a plurality of input pins configured to receive image data from an adjacent pixel.

The plurality of output pins may include an up output pin (DO_U) for outputting image data to an upper adjacent pixel, a down output pin (DO_D) for outputting image data to a lower adjacent pixel, a left output pin (DO_L) for outputting image data to a left adjacent pixel, and a right output pin (DO_R) for outputting image data to a right adjacent pixel.

The plurality of input pins may include a down input pin (DI_D) for receiving image data from an upper adjacent pixel, an up input pin (DI_U) for receiving image data from a lower adjacent pixel, a right input pin (DI_R) for receiving image data from a left adjacent pixel, and a left input pin (DI_L) for receiving image data from a right adjacent pixel.

According to yet another embodiment of the present invention, a display apparatus may include a controller configured to control data writing, light-emitting element driving, and data movement, and a first pixel and a second pixel. Each of the first pixel and the second pixel may include a pixel-embedded memory configured to store image data represented by a multi-bit value, wherein the pixel-embedded memory comprises: a first dummy shift register configured to retrieve 1-bit data stored in a pixel-embedded memory of an adjacent pixel; n-bit shift registers configured to store n-bit image data; and a second dummy shift register configured to retrieve 1-bit data stored in the n-bit shift registers during a data movement time interval.

When the first and second pixels are connected to the same column line, image data shift between left and right adjacent pixels may be performed over n+1 line times.
When the first pixel is connected to a first column line and the second pixel is connected to a second column line, and image data is shifted from the first pixel to the second pixel, the first pixel may perform bit-wise shifting in the order of its first dummy shift register, second dummy shift register, and n-bit shift registers during a clock cycle of the first column line. The second pixel may perform bit-wise shifting in the same order during a clock cycle of the second line that is delayed by one line time relative to the clock cycle of the first column line.

### [Advantageous effects]

According to embodiments of the present invention, image data shifting within a display may be supported without additional power consumption or time-related loss.
Furthermore, by supporting image data shifting within the display through the embodiments of the present invention, the applicability and versatility of display apparatuss in various applications may be enhanced.

### [Description of Drawings]

FIG. 1 illustrates a configuration of a display apparatus including a pixel according to an embodiment of the present invention.
FIG. 2 is a diagram for explaining an example of image movement within a display.
FIG. 3 is a diagram for explaining a driving scheme of a display for image data shifting according to an embodiment of the present invention.
FIG. 4 is a diagram for explaining a pixel and a pixel array of a display apparatus according to an embodiment of the present invention.
FIG. 5 is a diagram for explaining a schematic configuration of a pixel circuit included in each of the plurality of pixels shown in FIG. 4.
FIG. 6 is a diagram for explaining a detailed configuration of the pixel circuit included in each of the plurality of pixels shown in FIG. 4.
FIG. 7 is a diagram for explaining a clock connected to the pixel-embedded memory shown in FIG. 6.
FIG. 8 is a diagram for explaining the configuration and operation of shift registers shown in FIGS. 6 and 7.
FIG. 9 is a diagram showing an example configuration of the pixel-embedded memory shown in FIGS. 6 and 7.
FIGS. 10 to 12 are diagrams for explaining the operation timing of the display apparatus according to an embodiment of the present invention.
FIGS. 13 and 14 are diagrams for explaining the operation timing for image movement according to an embodiment of the present invention.
FIG. 15 is a diagram showing specific clock examples of CYCLE1 and CYCLE2 illustrated in FIG. 13.
FIG. 16 illustrates an example of a pixel array of the display apparatus according to an embodiment of the present invention.
FIGS. 17 and 18 are diagrams for explaining an example in which image data is shifted to a right adjacent pixel in the pixel array shown in FIG. 16.
FIGS. 19 to 21 are diagrams for explaining an example in which image data is shifted to a lower adjacent pixel in the pixel array shown in FIG. 16.
FIGS. 22 to 24 are diagrams for explaining an example in which image data is shifted to an upper adjacent pixel in the pixel array shown in FIG. 16.

### [Best Mode]

The structural or functional descriptions provided herein are merely illustrative examples intended to explain embodiments in accordance with the concept of the present invention. Embodiments according to the concept of the present invention may be implemented in various forms and are not limited to the embodiments described in this specification.

The embodiments in accordance with the concept of the present invention may be subject to various modifications and may take on a variety of forms. Specific embodiments are illustrated in the drawings and will be described in detail herein. However, this is not intended to limit the present invention to the specific embodiments disclosed, and it should be understood that the invention includes substitutions, modifications, equivalents, and alternatives falling within the spirit and scope of the invention.

Terms such as 'first' and 'second' may be used to describe various elements, but such terms should not be construed as limiting the elements. These terms are used merely to distinguish one element from another, and for example, without departing from the scope of the invention, a 'first' element may be referred to as a 'second' element, and similarly, a 'second' element may be referred to as a 'first' element.

When an element is referred to as being 'connected to' or 'coupled to' another element, it may be directly connected or coupled to the other element or may be indirectly connected or coupled through another element. In contrast, when an element is referred to as being 'directly connected to' or 'directly coupled to' another element, it means that there are no intervening elements between them. Other relational terms, such as 'between,' 'immediately between,' or 'adjacent to,' should be interpreted in the same manner.

The terminology used in this specification is intended to describe particular embodiments and is not intended to limit the scope of the invention. Unless the context clearly indicates otherwise, the singular forms include plural forms as well. As used herein, the terms 'comprise,' 'include,' or 'have' are intended to specify the presence of stated features, numbers, steps, operations, components, parts, or combinations thereof, but do not preclude the presence or addition of one or more other features, numbers, steps, operations, components, parts, or combinations thereof.

Unless otherwise defined, all technical and scientific terms used herein have the same meanings as commonly understood by one of ordinary skill in the art to which the invention belongs. Terms defined in generally accepted dictionaries should be interpreted as having meanings consistent with their contextual usage in the relevant technical field and should not be interpreted in an overly formal or idealized sense unless explicitly defined otherwise in this specification.

Hereinafter, embodiments of the present invention will be described in detail with reference to the accompanying drawings. However, the scope of the present patent application is not limited or restricted by these embodiments. The same reference numerals denote the same components throughout the drawings.

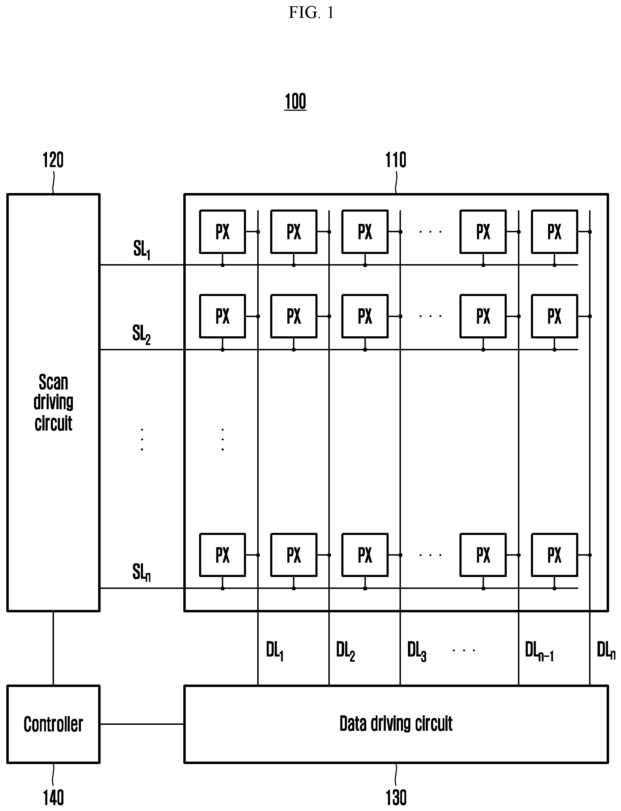

FIG. 1 illustrates a configuration of a display apparatus including a pixel according to an embodiment of the present invention.

Referring to FIG. 1, the display apparatus 100 may include a display panel 110, a scan driving circuit 120, a data driving circuit 130, and a controller 140. In this specification, the scan driving circuit 120 may also be referred to as a row driving circuit, and the data driving circuit 130 may also be referred to as a column driving circuit.

The display panel 110 may include a plurality of pixels (PX). In one embodiment, the plurality of pixels PX may be arranged in the form of an M × N matrix, where M and N are natural numbers. However, the arrangement of the pixels PX is not limited to a matrix structure and may be implemented in various patterns, such as a zigzag configuration, depending on the embodiment.

Each of the plurality of pixels PX may include one or more light-emitting elements. In one embodiment, the light-emitting element may be a light-emitting diode (LED). The light-emitting diode may be a micro LED having a size of 80 µm or less.

Each pixel PX may include a pixel driving circuit configured to drive the light-emitting elements, i.e., sub-pixels, included in the pixel.

The display panel 110 may include one or more scan lines (SL1 to SLm) arranged in a row direction and one or more data lines (DL1 to DLn) arranged in a column direction. Each pixel PX may be connected to one of the scan lines SLk and one of the data lines DLk. The one or more scan lines (SL1 to SLm) may be connected to the scan driving circuit 120, and the one or more data lines (DL1 to DLn) may be connected to the data driving circuit 130.

The scan driving circuit 120 may output a signal (hereinafter referred to as a row signal) that causes one or more pixels connected to one of the scan lines (SL1 to SLm) to be driven.

The data driving circuit 130 may output a signal (hereinafter referred to as a column signal) related to gradation to each of the pixels through the one or more data lines (DL1 to DLn). That is, the column signal may correspond to bit values of image data.

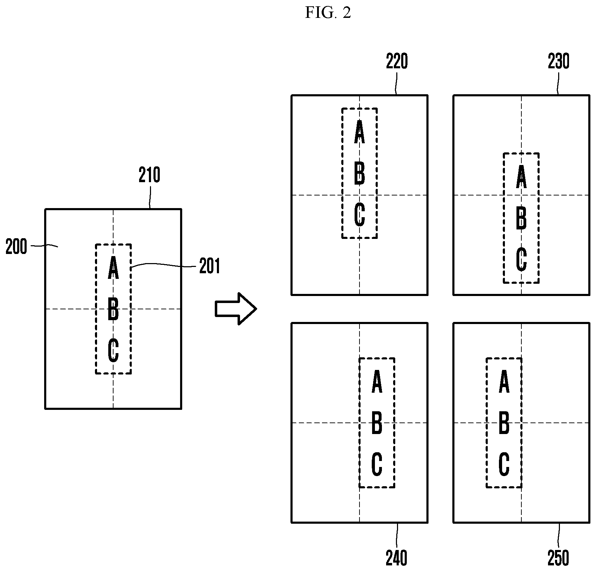

FIG. 2 is a diagram illustrating an example of image movement within a display.

Referring to FIG. 2, an application may operate in a first state 210, in which an object image 201 is displayed at a central region of a display 200.

When the user is positioned close to the display 200, the user may perceive the object image 201 in a distorted form depending on the movement of the eye's focal point. To reduce this phenomenon in which the object image 201 is perceived in a distorted manner, it may be necessary to shift the position of the object image 201 in accordance with the user's focal point. In other words, to reduce distortion in image perception, the display apparatus may need to move the image within the display.

The image movement may include at least one of the following states: a second state 220 in which the object image 201 is moved upward, a third state 230 in which the object image 201 is moved downward, a fourth state 240 in which the object image 201 is moved to the right, and a fifth state 250 in which the object image 201 is moved to the left.

In conventional techniques, image movement typically requires continuous updating of the image data stored in the pixel array. For example, to change from the first state 210 to the second state 220, the image data of all pixels must be updated per unit time. Accordingly, conventional approaches to image movement may increase power consumption and data transfer. Moreover, such image movement may involve repeated operations within a short period of time, resulting in inefficiencies.

In embodiments of the present invention, the image movement may be implemented as movement of image data from the perspective of display driving. A display apparatus according to an embodiment of the present invention may include an pixel-embedded memory for each pixel. The display apparatus may be configured to move image data stored in the pixel-embedded memory to an adjacent pixel. Therefore, the display apparatus may move image data to one of the adjacent pixels in the upward, downward, leftward, or rightward direction within the display.

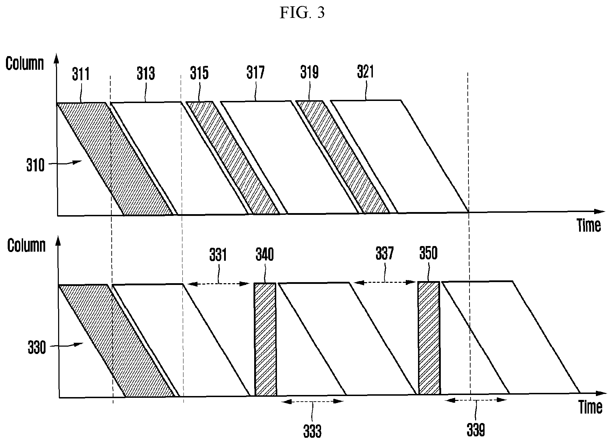

FIG. 3 is a diagram illustrating a display driving scheme for shifting image data according to an embodiment of the present invention.

Referring to FIG. 3, reference numeral 310 illustrates an example in which the image data is shifted in accordance with the column line driving sequence, and reference numeral 330 illustrates an example in which the image data is shifted simultaneously regardless of the column line driving sequence.

The method shown by reference numeral 310 may be configured in the following sequence: an image data write or image data storage interval 311, a lighting element driving interval 313, a data shift interval 315, a lighting element driving interval 317, a data shift interval 319, and a lighting element driving interval 321.

Here, during the data shift interval 315, the movement of data between adjacent pixels may proceed sequentially on a column line basis. Therefore, the method illustrated by reference numeral 310 may reduce display-on time loss and power consumption compared to the method illustrated by reference numeral 330.

The method shown by reference numeral 330 is a scheme in which the data is shifted simultaneously across all column lines during the data shift intervals 340 and 350, without proceeding sequentially on a column line basis. In this case, loss intervals 331, 333, 337, and 339 due to the display being in an ON state may occur. Accordingly, the method shown by reference numeral 330 may result in greater power consumption than the method shown by reference numeral 310.

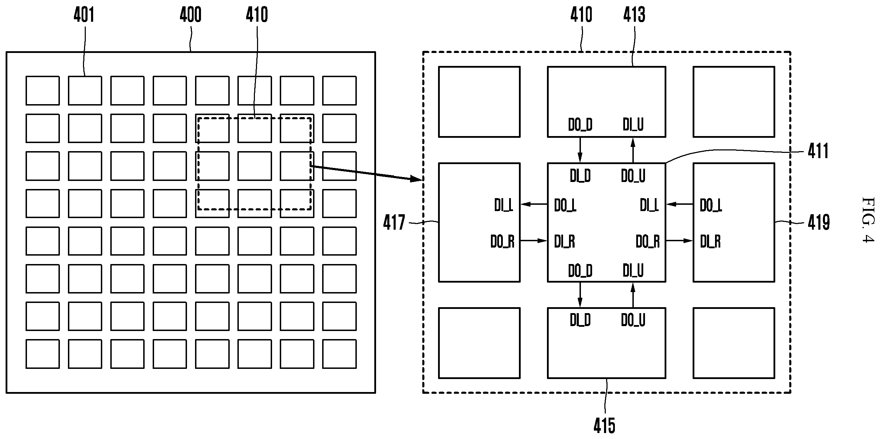

FIG. 4 is a diagram illustrating a pixel and a pixel array of a display apparatus according to an embodiment of the present invention.

Referring to FIG. 4, the display apparatus 400 includes a controller (not shown) and pixels 410. The controller may be provided in any one of the display panel 110, scan driving circuit 120, data driving circuit 130, or the controller 140 described in FIG. 1. The controller may control data writing, driving of light-emitting elements, and data movement.

For example, a specific region 410 of the pixel array may include a plurality of pixels 411, 413, 415, 417, and 419. Each of the plurality of pixels 411, 413, 415, 417, and 419 may include a pixel-embedded memory configured to store image data represented by a multi-bit value. The image data may be n-bit video data applied through column lines during a data write time interval. The image data may be expressed as a multi-bit value composed of a most significant bit (MSB) to a least significant bit (LSB).

The pixel-embedded memory may store at least one bit of data. The pixel-embedded memory may be implemented as a memory having fewer than n bits depending on the driving frequency. The pixel-embedded memory may include a shift register. The pixel-embedded memory may be implemented using one or more transistors, and may be realized as a random access memory (RAM), such as SRAM or DRAM.

The pixel 411 may include a plurality of output pins for outputting image data stored in the pixel-embedded memory to adjacent pixels based on a control signal input from the controller during a data movement time interval, and a plurality of input pins for receiving image data from adjacent pixels.

Hereinafter, the plurality of output pins and input pins will be described using pixel 411 as an example. The plurality of output pins may include an up output pin (DO_U) for outputting image data to an upper adjacent pixel 413, a down output pin (DO_D) for outputting image data to a lower adjacent pixel 415, a left output pin (DO_L) for outputting image data to a left adjacent pixel 417, and a right output pin (DO_R) for outputting image data to a right adjacent pixel 419.

The plurality of input pins may include a down input pin (DI_D) for receiving image data from the upper adjacent pixel 413, an up input pin (DI_U) for receiving image data from the lower adjacent pixel 415, a right input pin (DI_R) for receiving image data from the left adjacent pixel 417, and a left input pin (DI_L) for receiving image data from the right adjacent pixel 419.

The up output pin (DO_U) of the pixel 411 may be connected to the up input pin (DI_U) of the upper adjacent pixel 413. The down input pin (DI_D) of the pixel 411 may be connected to the down output pin (DO_D) of the upper adjacent pixel 413.

As such, each pixel according to the embodiment of the present invention may include interfaces for exchanging image data with adjacent pixels.

Each of the plurality of pixels 411, 413, 415, 417, and 419 may store image data in the pixel-embedded memory during a data write time interval, and may shift the image data stored in the pixel-embedded memory to one of the adjacent pixels in the upward, downward, leftward, or rightward direction based on a control signal input from the controller during a data movement time interval.

In other words, each of the plurality of pixels 411, 413, 415, 417, and 419 stores image data expressed as a multi-bit value in the pixel-embedded memory of each pixel during the data write time interval, receives a control signal for controlling data movement during the data movement time interval, and shifts the image data stored in the pixel-embedded memory to one of the adjacent pixels in the upward, downward, leftward, or rightward direction based on the control signal.

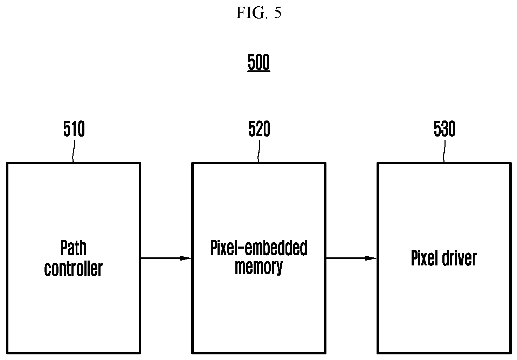

FIG. 5 is a diagram illustrating a schematic configuration of a pixel circuit provided in each of the plurality of pixels shown in FIG. 4.

The pixel circuit 500 may be connected to a light-emitting element.

Referring to FIG. 5, the pixel circuit 500 includes a path controller 510 and a pixel-embedded memory 520. The pixel circuit 500 may further include a pixel driver 530 configured to drive the light-emitting element.

The path controller 510 selects a connection path to adjacent pixels based on a control signal input from the controller.

The path controller 510 may include a first path controller configured to select a reception path for image data based on the type of the control signal, and a second path controller configured to select an output path for image data based on the type of the control signal.

The pixel-embedded memory 520 stores image data represented as a multi-bit value during a data write time interval, and shifts the image data through a connection path with an adjacent pixel during a data movement time interval.

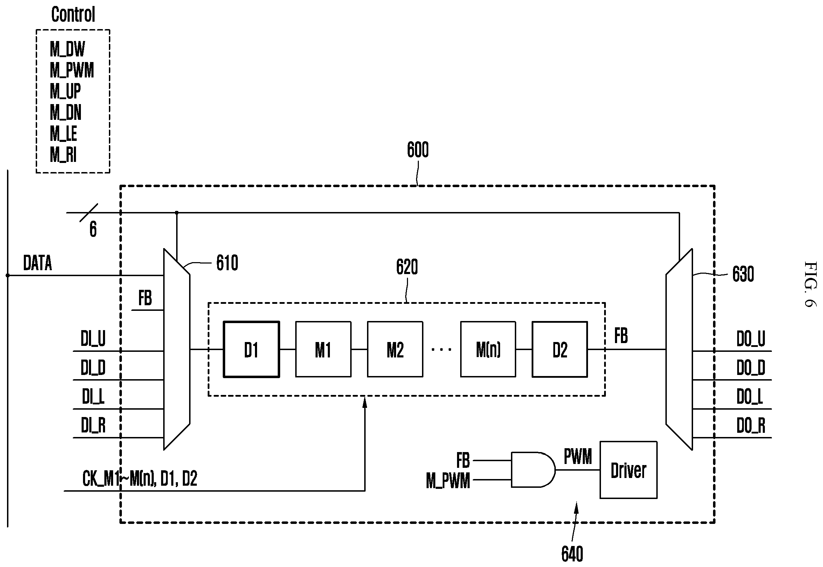

FIG. 6 is a diagram illustrating a detailed configuration of a pixel circuit included in each of the plurality of pixels shown in FIG. 4.

Referring to FIG. 6, a pixel circuit 600 includes a first path controller 610, a pixel-embedded memory 620, and a second path controller 630. The pixel circuit 600 may further include a pixel driver 640 configured to drive a light-emitting element.

The first path controller 610 is configured to select a reception path of image data based on the type of control signal. The second path controller 630 is configured to select an output path of image data based on the type of control signal.

The types of control signals for controlling image data movement may include: an up control signal (M_UP) for shifting image data to an upper adjacent pixel, a down control signal (M_DN) for shifting image data to a lower adjacent pixel, a left control signal (M_LE) for shifting image data to a left adjacent pixel, and a right control signal (M_RI) for shifting image data to a right adjacent pixel.

In the control signals (Control) illustrated in FIG. 6, the signal M_DW is a write command for writing data into the pixel-embedded memory during a data write interval. Accordingly, when the first path controller 610 receives M_DW, it may select a reception path for receiving data through a data line.

FIG. 6 illustrates a detailed configuration of a pixel circuit included in each of the plurality of pixels shown in FIG. 4.

Referring to FIG. 6, a pixel circuit (600) includes a first path controller (610), a pixel-embedded memory (620), and a second path controller (630). The pixel circuit (600) may further include a pixel driver (640) configured to drive a light-emitting element.

The first path controller (610) selects a reception path for image data based on the type of a control signal. The second path controller (630) selects an output path for the image data based on the type of the control signal.

The types of control signals for controlling the image data movement may include: an up control signal (M_UP) for shifting image data to an upper adjacent pixel, a down control signal (M_DN) for shifting image data to a lower adjacent pixel, a left control signal (M_LE) for shifting image data to a left adjacent pixel, and a right control signal (M_RI) for shifting image data to a right adjacent pixel.

Among the control signals shown in FIG. 6, M_PWM represents an instruction for driving the light-emitting element during a light-emitting element driving interval.

When the first path controller (610) receives the up control signal (M_UP), it may select the DI_U pin, which is connected to a lower adjacent pixel, as the reception path for image data. In this case, the up control signal (M_UP) may be simultaneously input to both the first path controller (610) and the second path controller (630). When the second path controller (630) receives the up control signal (M_UP), it may select the DO_U pin, which is connected to an upper adjacent pixel, as the output path for image data.

When the first path controller (610) receives the down control signal (M_DN), it may select the DI_D pin, which is connected to an upper adjacent pixel, as the reception path for image data. In this case, the down control signal (M_DN) may be simultaneously input to both the first path controller (610) and the second path controller (630). When the second path controller (630) receives the down control signal (M_DN), it may select the DO_D pin, which is connected to a lower adjacent pixel, as the output path.

When the first path controller (610) receives the left control signal (M_LE), it may select the DI_L pin, which is connected to a right adjacent pixel, as the reception path for image data. In this case, the left control signal (M_LE) may be simultaneously input to both the first path controller (610) and the second path controller (630). When the second path controller (630) receives the left control signal (M_LE), it may select the DO_L pin, which is connected to a left adjacent pixel, as the output path.

When the first path controller (610) receives the right control signal (M_RI), it may select the DI_R pin, which is connected to a left adjacent pixel, as the reception path for image data. In this case, the right control signal (M_RI) may be simultaneously input to both the first path controller (610) and the second path controller (630). When the second path controller (630) receives the right control signal (M_RI), it may select the DO_R pin, which is connected to a right adjacent pixel, as the output path.

The pixel-embedded memory (620) may include: a first dummy shift register (D1), n-bit shift registers (M1, M2, ..., M(n)), and a second dummy shift register (D2).

The dummy shift register D1 is a shift register configured to receive 1-bit data from the pixel-embedded memory of an adjacent pixel. The shift registers M1, M2, ..., M(n) are configured to store image data represented by n bits. The dummy shift register D2 is a shift register configured to extract 1-bit data from the n-bit shift registers, in particular from the shift register M(n).

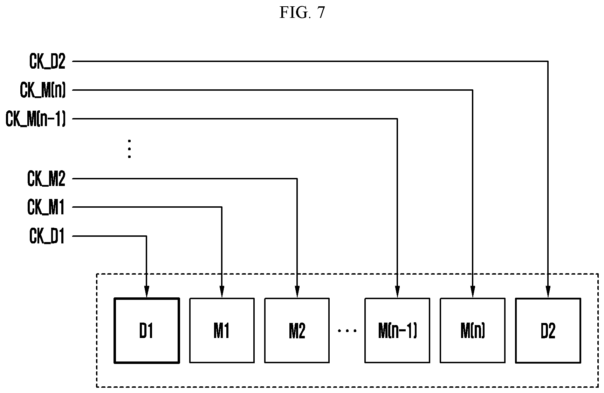

FIG. 7 illustrates a diagram for describing clocks connected to the pixel-embedded memory shown in FIG. 6.

Referring to FIG. 7, the shift registers D1, M1, M2, ..., M(n-1), M(n), and D2 may operate in response to respective clocks CK_D1, CK_M1, CK_M2, CK_M(n-1), CK_M(n), and CK_D2.

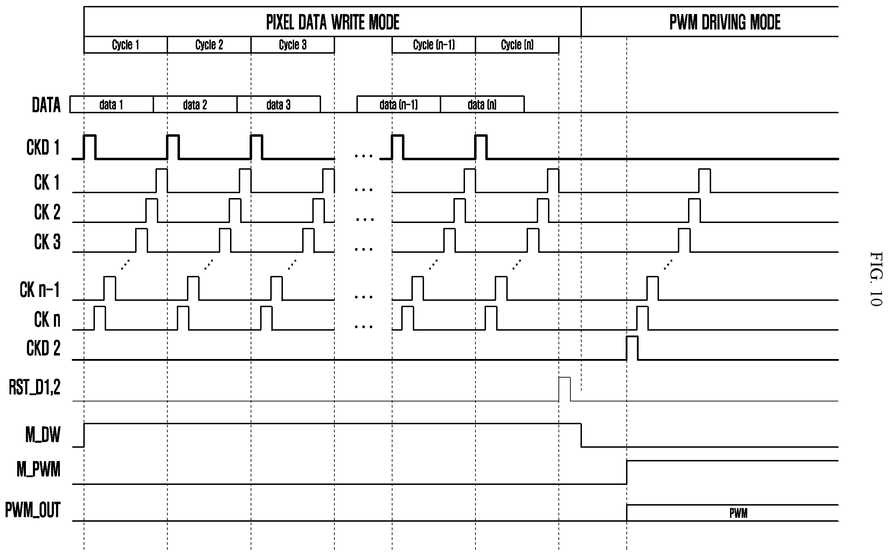

The specific timing diagrams for the clocks CK_D1, CK_M1, CK_M2, CK_M(n-1), CK_M(n), and CK_D2, which are used for operating the shift registers, will be described with reference to FIGS. 10 to 15.

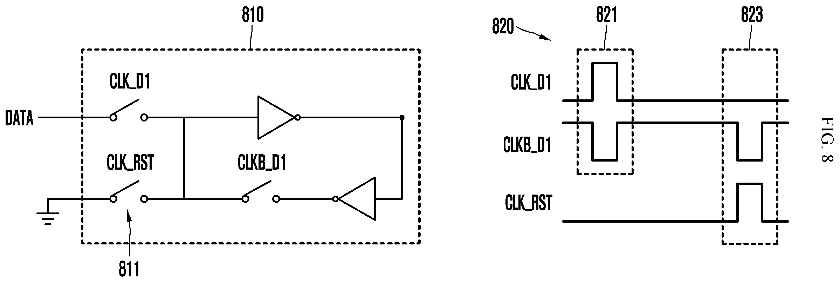

FIG. 8 illustrates a configuration and operation of the shift register shown in FIGS. 6 and 7.

Referring to FIG. 8, a shift register (810) may be a latch-based memory configured to minimize pixel size. The latch-based memory may include a memory structure for data storage and a switch (811) for reset.

Meanwhile, D1 and M1, M2, ..., M(n) shown in FIGS. 6 and 7 may have different structures.

For example, D1 may include the reset switch (811) as shown in FIG. 8, whereas M1, M2, ..., M(n) may have a structure that does not include the reset switch (811).

Referring to an exemplary timing diagram (820) for operating the shift register (810), the shift register (810) may perform a data shift operation during an interval (821) in which the clock signal CLK_D1 is activated, and may perform a reset operation to clear the remaining data during an interval (823) in which the clock signal CLK_RST is activated.

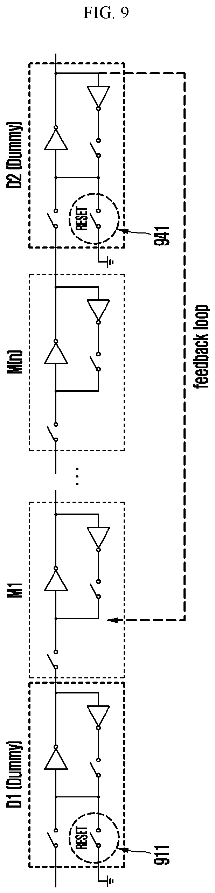

FIG. 9 illustrates an exemplary configuration of the pixel-embedded memory shown in FIGS. 6 and 7.

Referring to FIG. 9, D1 and D2 may have the same structure as the one illustrated in FIG. 8.

More specifically, D1 may include a reset switch (911) configured to reset the register after the image data is transferred.

D2 may include a reset switch (941) configured to reset the register after the image data is transferred.

Here, the reset switch (911) may operate after the image data writing operation is completed during the data write interval, in order to reset the data.

M1, M2, ..., M(n) may be latch-based memories configured merely for storing data.

In other words, M1, M2, ..., M(n) may have a structure that does not include a reset switch, unlike D1 or D2.

FIGS. 10 to 12 are diagrams illustrating operation timings of the display apparatus according to an embodiment of the present invention.

To explain the timing operation, the pixel circuit structure of FIG. 6 may be referenced.

Referring to FIG. 10, 'PIXEL DATA WRITE MODE' indicates a data write interval, and 'PIXEL DRIVING MODE' indicates a light-emitting device driving interval. The data write interval may correspond to the image data storage interval (311) of FIG. 3, for example.

The data write interval may include n clock cycles (Cycle1, Cycle2, Cycle3, ..., Cycle(n-1), Cycle(n)) for sequentially writing n-bit data data1, data2, data3, ..., data(n-1), data(n) into the pixel-embedded memory.

During the active period of the control signal M_DW, the clock CK_D1 for operating the first dummy shift register D1 may be first activated. Subsequently, the clocks CKn, CKn-1, ..., CK3, CK2, CK1 for operating M(n), M(n-1), ..., M3, M2, M1 in order from the output end may be sequentially activated.

During the data write interval, since the second dummy shift register D2 does not operate, CK_D2 may remain inactive.

At the end of the data write interval, RST_D1 is activated, and the reset switch of D1 may operate.

The clock M_PWM for driving the light-emitting device may be activated at the timing when the PIXEL DATA WRITE MODE ends.

The light-emitting device driving interval may correspond to the light-emitting device driving interval (313) of FIG. 3, for example.

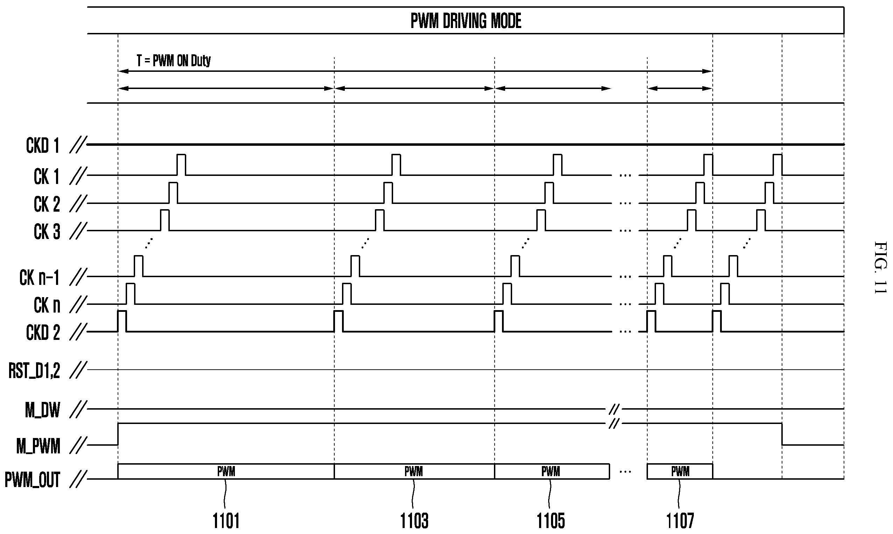

Referring to FIG. 11, the light-emitting device driving may include a period (1101) for driving data1, a period (1103) for driving data2, a period (1105) for driving data3, and a period (1107) for driving data(n). Here, data1 may be the MSB and data(n) may be the LSB.

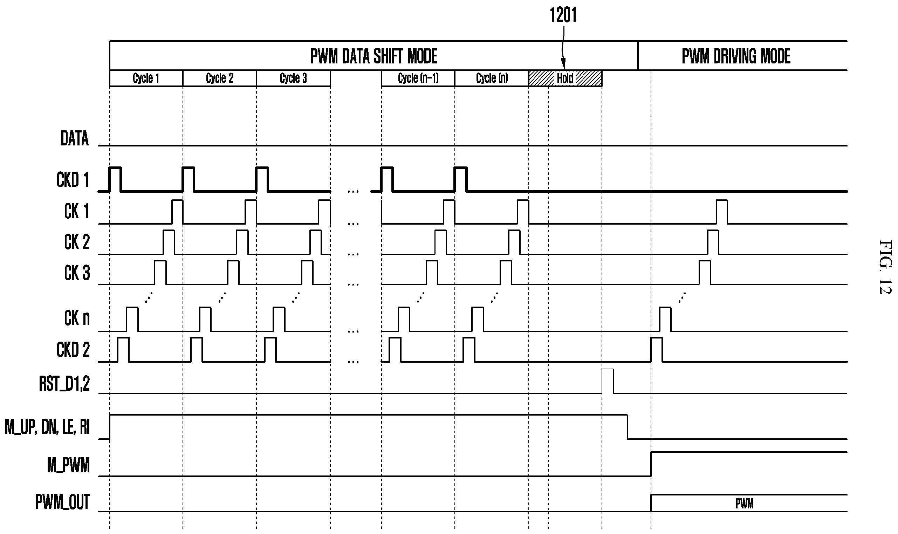

Referring to FIG. 12, 'PIXEL DATA SHIFT MODE' indicates a data shift interval. The data shift interval may correspond to the data shift interval (315) illustrated in FIG. 3, for example.

The data shift interval may include n clock cycles (Cycle1, Cycle2, Cycle3, ..., Cycle(n-1), Cycle(n)) and a hold interval (1201). The number of required clock cycles may vary depending on the direction of image data movement, and the hold interval (1201) may be required to perform data shifting on a column-line basis.

In FIG. 12, M_UP, M_DN, M_LE, and M_RI indicate types of control signals described with reference to FIG. 6 and are signals for controlling the movement direction of image data.

When the CK_D1 clock is activated, the first dummy shift register performs an operation of acquiring 1-bit data stored in the embedded memory of an adjacent pixel. In other words, the first dummy shift register may operate to acquire 1-bit data stored in the embedded memory of the adjacent pixel in a first clock cycle of the data shift interval.

After the CK_D1 clock, the CK_D2 clock may be activated, and the second dummy shift register may perform an operation of acquiring image data stored in M(n). That is, the second dummy shift register may operate to acquire 1-bit data stored in the n-bit shift registers in a second clock cycle of the data shift interval.

Following the CK_D2 clock, clocks for operating each of the n-bit shift registers may be activated. The activation order of the clocks may be CKn, CKn-1, ..., CK3, CK2, CK1. Accordingly, each of the n-bit shift registers may shift 1-bit data starting from a third clock cycle of the data shift interval.

At the end of the data shift interval, the reset signals RST_D1 and RST_D2 may be activated, and the reset switches of D1 and D2 may operate.

After the data shift operation is completed, the M_PWM clock for driving the light-emitting device may be activated at the timing when the PIXEL DATA SHIFT MODE ends.

The 'PIXEL DRIVING MODE' shown in FIG. 12 may be executed in the same manner as the 'PIXEL DRIVING MODE' shown in FIG. 10.

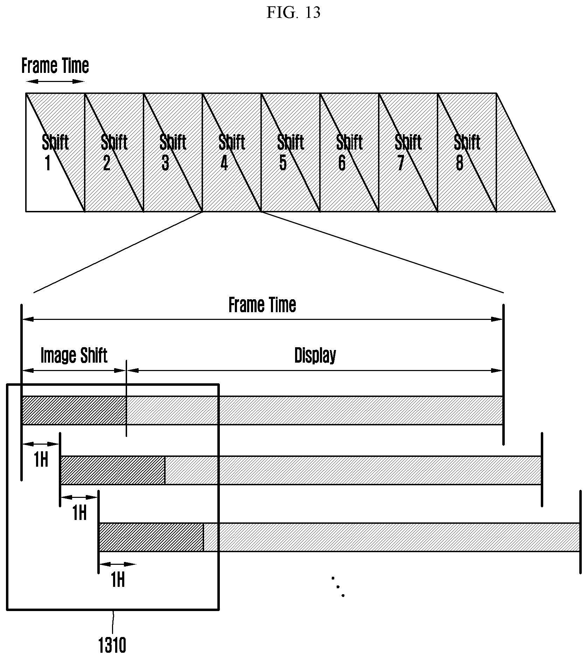

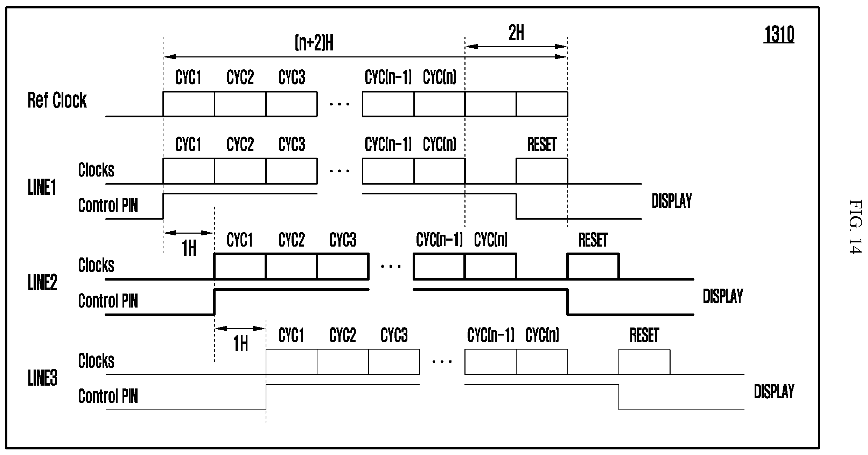

FIGS. 13 and 14 are diagrams for illustrating operation timings for image data shifting according to an embodiment of the present invention.

Referring to FIG. 13, 'Shift 1' through 'Shift 8' indicate successive image data shifting operations. The image shift may be performed once per frame time. The 'Display' following the image shift in FIG. 13 corresponds to a light-emitting period for driving the light-emitting device.

Since the image data shift may be performed on a column-line basis, the image shift interval (1310), from the perspective of the entire pixel array, may include a delay of one line time (1H) for each column line. Here, a line time denotes a time interval having a length corresponding to one clock cycle.

FIG. 14 illustrates detailed clock cycles and control pin timings for controlling the pin connections of pixels on a column-line basis. In FIG. 14, 'DISPLAY' denotes a light-emitting operation after the image data shift is completed.

When the number of bits in the image data is n, the shift of image data between left and right adjacent pixels on the same column line may be performed during a time interval of (n+1) line times, i.e., (n+1)H. For example, in order to shift 3-bit image data to a left or right adjacent pixel, four clock cycles may be required.

Meanwhile, an upward control signal (M_UP) for shifting image data to an upper adjacent pixel and a downward control signal (M_DN) for shifting image data to a lower adjacent pixel may require a different number of clock cycles from that required for left/right shifting.

For example, assume a first pixel is connected to a first column line (LINE1) and a second pixel is connected to a second column line (LINE2). When the image data is shifted from the first pixel to the second pixel, the first pixel may sequentially shift 1-bit data via its first dummy shift register, second dummy shift register, and n-bit shift registers during clock cycles CYC1 through CYC(n) of LINE1.

At this time, the second pixel may perform 1-bit data shifts via its first dummy shift register, second dummy shift register, and n-bit shift registers in the same sequence during the clock cycles CYC1 through CYC(n) of LINE2, which is delayed by one line time with respect to the clock cycles of LINE1.

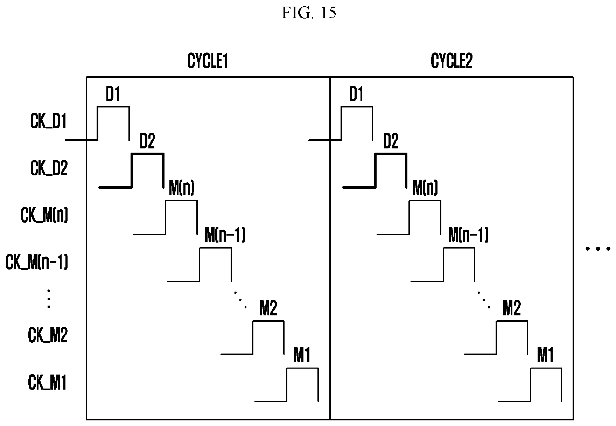

FIG. 15 is a diagram illustrating an example of specific clock signals corresponding to CYCLE1 and CYCLE2 shown in FIG. 13.

Referring to FIG. 15, the activation order of the clock signals may be determined based on the operating sequence of the shift registers in the pixel-embedded memory.

Accordingly, the clock signal CK_D1 may be activated first, followed by the activation of the clock signal CK_D2. The second dummy shift register may perform an operation to fetch image data stored in M(n).

After the activation of CK_D2, the clock signals for operating the respective n-bit shift registers may be activated. The activation sequence of the clock signals may follow the order of CK_M(n), CK_M(n-1), ..., CK_M2, and CK_M1.

Therefore, the pixel-embedded memory may operate in the order of D1, D2, and M(n) to M1.

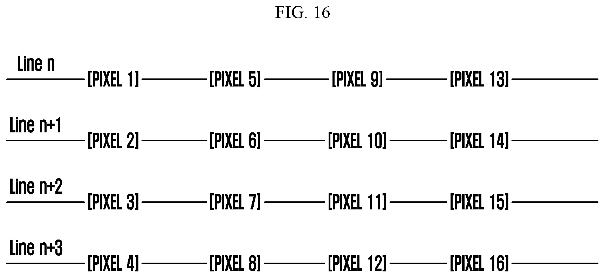

FIG. 16 illustrates an example of a pixel array of a display apparatus according to an embodiment of the present invention.

FIG. 16 shows an example of a 4×4 pixel array, which may represent a portion of an entire pixel array. Column lines Line n, Line n+1, Line n+2, and Line n+3 respectively represent column lines.

PIXEL 1, PIXEL 5, PIXEL 9, and PIXEL 13 are connected to column line Line n.

PIXEL 2, PIXEL 6, PIXEL 10, and PIXEL 14, which are positioned below the pixels connected to Line n, are connected to column line Line n+1.

PIXEL 3, PIXEL 7, PIXEL 11, and PIXEL 15, which are positioned below the pixels connected to Line n+1, are connected to column line Line n+2.

PIXEL 4, PIXEL 8, PIXEL 12, and PIXEL 16, which are positioned below the pixels connected to Line n+2, are connected to column line Line n+3.

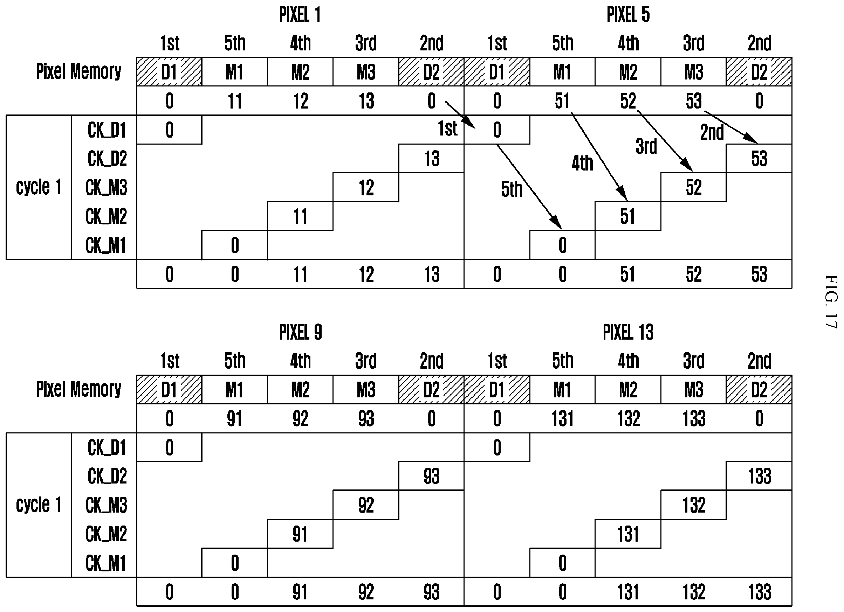

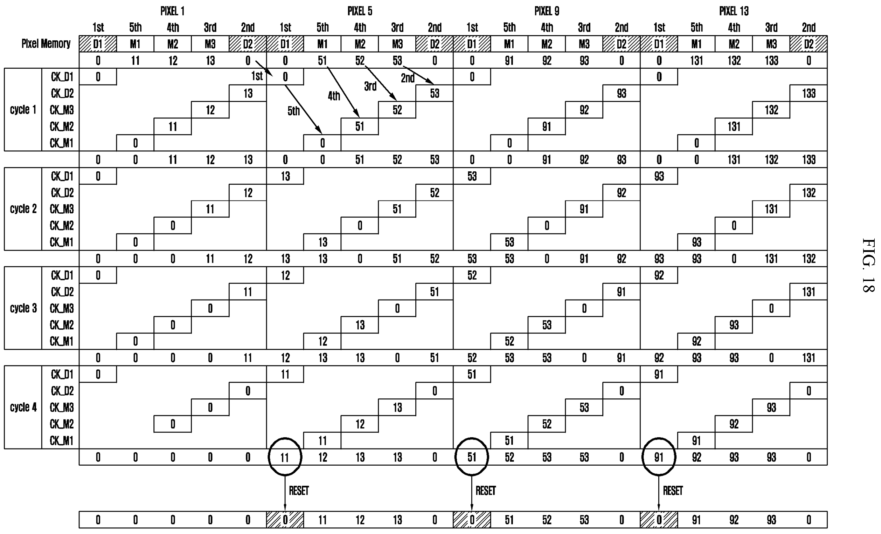

FIGS. 17 and 18 are diagrams for explaining an example in which image data is shifted to the right pixel in the pixel array illustrated in FIG. 16.

The examples shown in FIGS. 17 and 18 illustrate the image data shifting of PIXEL 1, PIXEL 5, PIXEL 9, and PIXEL 13, which are connected to Line n. In this example, the image data is assumed to be 3 bits. For the purpose of distinguishing the data stored in each pixel during the pixel data write mode, the data stored in PIXEL 1 is denoted as '11', '12', and '13'; the data stored in PIXEL 5 is denoted as '51', '52', and '53'; the data stored in PIXEL 9 is denoted as '91', '92', and '93'; and the data stored in PIXEL 13 is denoted as '131', '132', and '133'.

FIG. 17 illustrates the operation of each pixel during a first clock cycle, cycle1.

During the first clock cycle cycle1, the D1 register of each pixel operates first.

For example, the D1 register of PIXEL 5 receives the data '0' stored in the D2 register of the left-adjacent PIXEL 1. In other words, the data '0' stored in the D2 register of PIXEL 1 is shifted to the D1 register of PIXEL 5.

When the clock CK_D2 is activated, each pixel's D2 register retrieves the data stored in the M3 register. For example, the D2 register of PIXEL 5 retrieves the data '53' stored in its M3 register.

FIG. 18 illustrates an example of an overall data shift operation from cycle 1 to cycle 4.

After the data shift operations from cycle 1 to cycle 4 are completed, all shift registers in PIXEL 1 remain filled with dummy data represented as '0'.

The image data '11', '12', and '13' shifted from PIXEL 1 to the right adjacent pixel are stored in the pixel-embedded memory of PIXEL 5.

The image data '51', '52', and '53' shifted from PIXEL 5 to the right adjacent pixel are stored in the pixel-embedded memory of PIXEL 9.

The image data '91', '92', and '93' shifted from PIXEL 9 to the right adjacent pixel are stored in the pixel-embedded memory of PIXEL 13.

Referring to FIG. 18, each pixel performs a reset operation at a reset timing to remove residual garbage data remaining in the first and second dummy shift registers (D1 and D2).

For example, the D1 of PIXEL 5 deletes the data '11' through the reset operation and maintains the dummy data state of '0'.

The D1 of PIXEL 9 deletes the data '51' through the reset operation and maintains the dummy data state of '0'.

The D1 of PIXEL 13 deletes the data '91' through the reset operation and maintains the dummy data state of '0'.

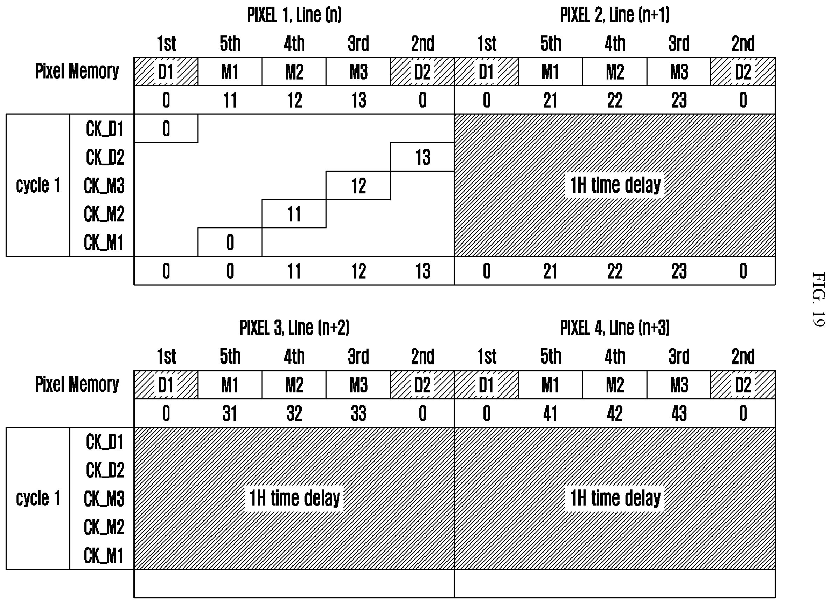

FIGs. 19 through 21 illustrate examples of image data being shifted to a lower pixel in the pixel array illustrated in FIG. 16.

The examples shown in FIGs. 19 through 21 depict a case in which image data is sequentially shifted from PIXEL 1 connected to Line n, to PIXEL 2 connected to Line n+1, to PIXEL 3 connected to Line n+2, and to PIXEL 4 connected to Line n+3.

FIG. 19 illustrates the operation of the pixel-embedded memory in each pixel during cycle 1 of Line n.

According to the embodiment of the present invention, the image data shift operation may be sequentially performed line by line with a time difference of one line time.

Accordingly, in cycle 1 of Line n, only the pixel-embedded memory of PIXEL 1 performs a shift operation, while the pixels of other lines remain inactive.

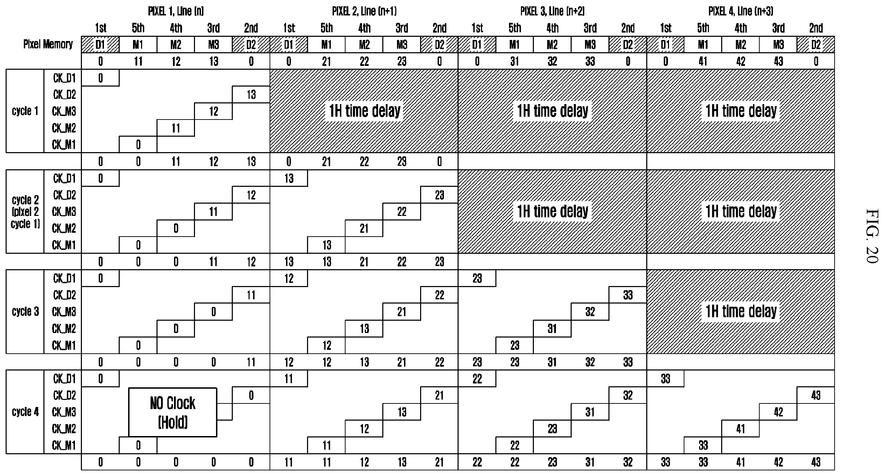

FIG. 20 illustrates the image data shift operation executed over four clock cycles.

In FIG. 20, cycle 2 corresponds to a one-line-time-delayed cycle 1 (i.e., cycle 1 of PIXEL 2) from the perspective of Line n+1.

Accordingly, the pixel-embedded memories of both PIXEL 1 and PIXEL 2 perform shift operations.

For example, when the CK_D1 clock is activated, the first dummy shift register (D1) of PIXEL 2 retrieves the data '13' stored in the second dummy shift register (D2) of the upper adjacent pixel.

In the fourth clock cycle (cycle 4), PIXEL 1 does not receive any clock input and remains in a hold state without performing a shift operation.

At this time, PIXEL 2, PIXEL 3, and PIXEL 4 respectively perform shift operations.

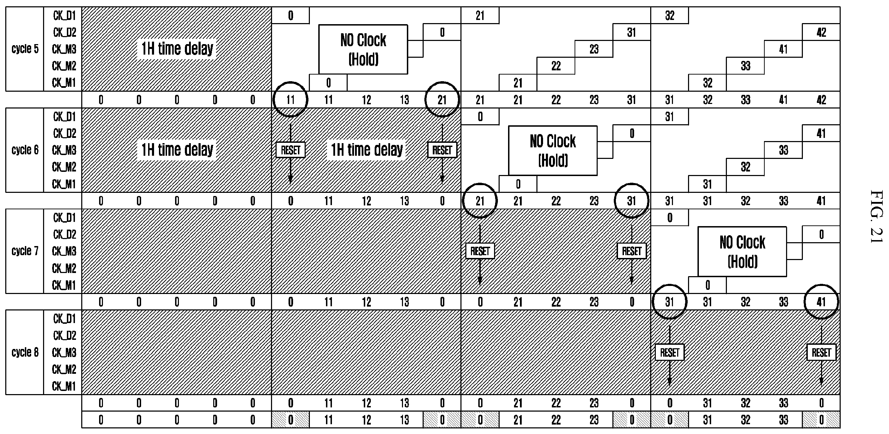

FIG. 21 illustrates operations performed after the sequence shown in FIG. 20.

In the fifth clock cycle (cycle 5), PIXEL 2 does not receive any clock input and remains in a hold state without performing a shift operation.

At this time, PIXEL 3 and PIXEL 4 respectively perform shift operations.

In the sixth clock cycle (cycle 6), PIXEL 2 performs a reset operation to initialize its first and second dummy shift registers (D1 and D2).

Meanwhile, PIXEL 3 remains in a hold state, and PIXEL 4 performs a shift operation.

In cycle 7, PIXEL 3 performs a reset operation, and PIXEL 4 remains in a hold state.

Subsequently, in cycle 8, PIXEL 4 performs a reset operation to initialize its D1 and D2.

Referring to FIG. 21, the image data '11', '12', and '13' shifted from PIXEL 1 are stored in the pixel-embedded memory of PIXEL 2; '21', '22', and '23' are stored in the pixel-embedded memory of PIXEL 3; and '31', '32', and '33' are stored in the pixel-embedded memory of PIXEL 4.

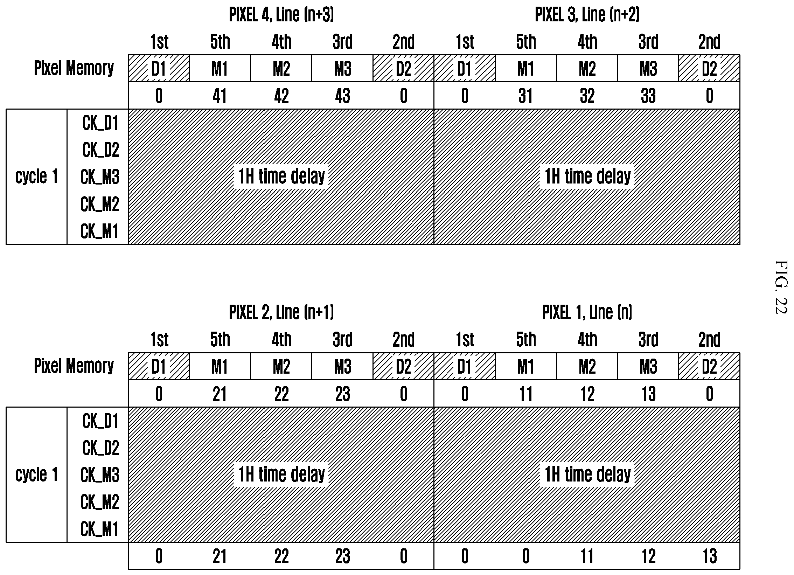

FIGS. 22 to 24 illustrate an example of image data being shifted to upper pixels in the pixel array shown in FIG. 16.

The examples depicted in FIGS. 22 to 24 illustrate a case in which the image data is sequentially shifted from PIXEL 4 (connected to Line n+3), to PIXEL 3 (connected to Line n+2), to PIXEL 2 (connected to Line n+1), and finally to PIXEL 1 (connected to Line n).

In other words, FIGS. 22 to 24 represent a case in which an upward control signal (M_UP) is executed to shift image data from PIXEL 4, PIXEL 3, PIXEL 2, and PIXEL 1 to their respective upper adjacent pixels.

FIG. 22 illustrates the operation of the pixel-embedded memory in each pixel during cycle 1 of Line n.

When the driving sequence is maintained line by line as shown in reference numeral 310 of FIG. 3, the upward control signal (M_UP) causes the column lines to operate starting from the topmost line.

Accordingly, in cycle 1, PIXEL 1 connected to Line n sequentially operates its D1, D2, M3, M2, and M1 in that order.

At this time, pixels connected to lines other than Line n do not operate.

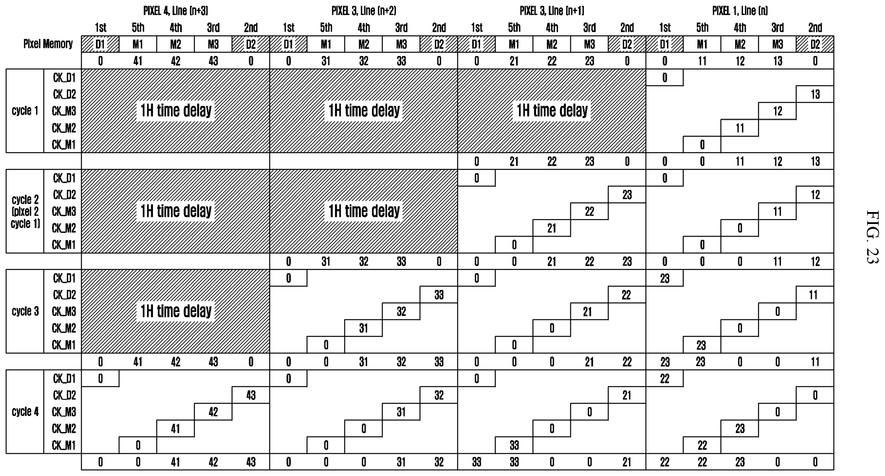

FIG. 23 illustrates image data shifting performed over four clock cycles.

In FIG. 23, cycle 2 corresponds to cycle 1 of PIXEL 2 (i.e., pixel2 cycle1), delayed by one line time (1H) from the perspective of Line n+1.

Thus, the pixel-embedded memories of PIXEL 1 and PIXEL 2 respectively perform shift operations.

For example, when the CK_D1 clock is activated, the D1 of PIXEL 1 may acquire the data '0' stored in the D2 of its lower adjacent pixel, PIXEL 2.

Referring to FIG. 23, the upward control (M_UP) may be sequentially executed line by line over four clock cycles.

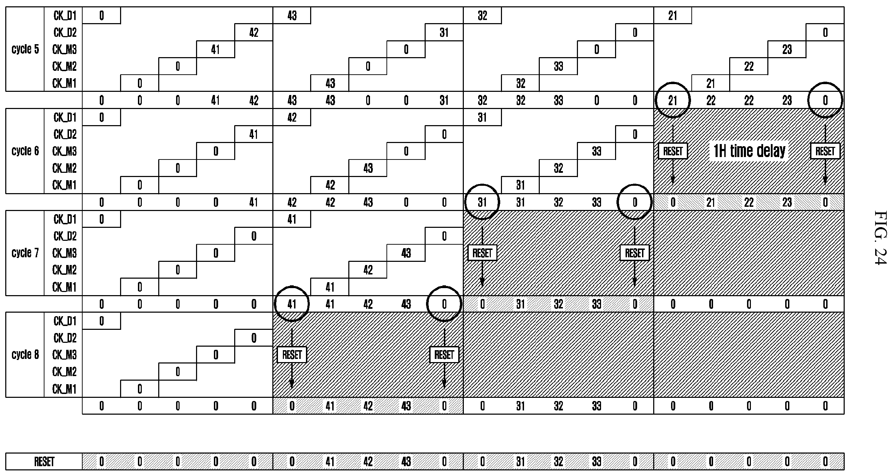

FIG. 24 illustrates the operation performed after the sequence shown in FIG. 23.

For example, in the fifth clock cycle (cycle 5), the image data '21', '22', and '23' are respectively stored in M1, M2, and M3 of PIXEL 1.

In cycle 6, PIXEL 1 performs a reset operation for D1 and D2.

Subsequently, in cycle 7, PIXEL 2 performs a reset operation for D1 and D2.

In cycle 8, PIXEL 3 performs a reset operation for D1 and D2.

Upon completion of the upward control (M_UP), the image data '21', '22', and '23' shifted from PIXEL 2 are stored in PIXEL 1; '31', '32', and '33' are stored in PIXEL 2; and '41', '42', and '43' are stored in PIXEL 3.

It should be understood that the devices described above may be implemented using hardware components, software components, or a combination of hardware and software components. For example, the devices and components described in the embodiments may be implemented using one or more general-purpose computers or special-purpose computers, such as a processor, controller, arithmetic logic unit (ALU), digital signal processor (DSP), microcomputer, field programmable array (FPA), programmable logic unit (PLU), microprocessor, or any other device capable of executing and responding to instructions.

The processing device may execute an operating system (OS) and one or more software applications running on the OS. Additionally, in response to the execution of software, the processing device may access, store, manipulate, process, or generate data. While a single processing device is sometimes described for the sake of convenience, those skilled in the art will understand that the processing device may include multiple processing elements and/or multiple types of processing elements. For example, the processing device may include multiple processors, or a combination of a processor and a controller. Other processing configurations, such as parallel processors, may also be used.

The software may include a computer program, code, instructions, or a combination thereof, and may configure or collectively instruct the processing device to operate in a desired manner. The software and/or data may be embodied permanently or temporarily in any type of machine, component, physical device, virtual equipment, computer-readable storage medium or device, or propagated signal wave to be interpreted by the processing device or to provide commands or data to the processing device. The software may also be distributed across networked computer systems, stored or executed in a distributed manner. The software and data may be stored in one or more computer-readable recording media.

The method according to an embodiment may be implemented as program instructions that may be executed through various computer means and recorded in a computer-readable medium. The computer-readable medium may include program instructions, data files, data structures, or combinations thereof. The program instructions recorded on the medium may be specially designed and configured for the embodiments, or may be known and available to those skilled in the field of computer software.

Examples of the computer-readable recording media include magnetic media such as hard disks, floppy disks, and magnetic tapes; optical media such as CD-ROMs and DVDs; magnetooptical media such as floptical disks; and hardware devices specially configured to store and execute program instructions, such as ROM, RAM, and flash memory. Examples of program instructions include machine code generated by a compiler as well as high-level language code executable by a computer using an interpreter or the like.

The above-described hardware devices may be configured to operate as one or more software modules to perform the operations of the embodiments, and vice versa.

Although the embodiments have been described above with reference to specific drawings, it will be apparent to those skilled in the art that various modifications and alterations may be made based on the above description. For example, the described techniques may be performed in a different order than that described; and/or the described systems, structures, devices, or circuits may be combined or integrated in different forms, or replaced or substituted with other components or equivalents to achieve substantially the same result.
Accordingly, other implementations, modifications, and equivalents to the embodiments described herein are intended to fall within the scope of the following claims.

## Claims

1. A display apparatus comprising:
a controller configured to control data writing, driving of a light-emitting element, and data movement; and
a plurality of pixels each including a pixel-embedded memory configured to store image data represented by a multi-bit value,
wherein each of the plurality of pixels is configured to store the image data in the pixel-embedded memory during a data write time interval, and
shift the image data stored in the pixel-embedded memory to one of upper, lower, left, or right adjacent pixels based on a control signal input from the controller during a data movement time interval.

2. The display apparatus according to claim 1,
wherein the pixel-embedded memory comprises:
a first dummy shift register configured to retrieve 1-bit data stored in a pixel-embedded memory of an adjacent pixel;
n-bit shift registers configured to store n-bit image data; and
a second dummy shift register configured to retrieve 1-bit data stored in the n-bit shift registers.

3. The display apparatus according to claim 2,
wherein the first dummy shift register operates to retrieve 1-bit data stored in the pixel-embedded memory of the adjacent pixel at a first clock of the data movement time interval,
the second dummy shift register operates to retrieve 1-bit data stored in the n-bit shift registers at a second clock of the data movement time interval, and
each of the n-bit shift registers is configured to shift 1-bit data starting from a third clock of the data movement time interval.

4. The display apparatus according to claim 2,
wherein the first dummy shift register and the second dummy shift register include a reset switch for resetting the registers after the movement of the image data.

5. The display apparatus according to claim 2,
wherein image data shift between left and right adjacent pixels connected to the same column line is performed during n+1 line times.

6. The display apparatus according to claim 5,
wherein image data shift between upper and lower adjacent pixels includes image data shift from a first pixel of a first column line to a second pixel of a second column line,
the first pixel performs bit-wise shift in the order of a first dummy shift register, a second dummy shift register, and the n-bit shift registers during a clock cycle of the first column line, and
the second pixel performs bit-wise shift in the order of a first dummy shift register, a second dummy shift register, and the n-bit shift registers during a clock cycle of the second line delayed by one line time compared to the clock cycle of the first column line.

7. A method of supporting data movement in a display apparatus, the method comprising:
storing image data represented by a multi-bit value in a pixel-embedded memory of each of a plurality of pixels during a data write time interval;
receiving a control signal for controlling data movement during a data movement time interval; and
shifting the image data stored in the pixel-embedded memory to one of upper, lower, left, or right adjacent pixels based on the control signal.

8. A pixel of a display apparatus comprising:
a light-emitting element; and
a pixel circuit connected to the light-emitting element,
wherein the pixel circuit comprises:
a path controller configured to select a connection path with an adjacent pixel based on a control signal input from a controller; and
a pixel-embedded memory configured to store image data represented by a multi-bit value during a data write time interval, and shift the image data through the connection path with the adjacent pixel during a data movement time interval.

9. The pixel of the display apparatus according to claim 8,
wherein the path controller comprises:
a first path controller configured to select a reception path of the image data based on a type of the control signal; and
a second path controller configured to select an output path of the image data based on the type of the control signal.

10. The pixel of the display apparatus according to claim 9,
wherein the type of the control signal comprises:
an up control signal (M_UP) for moving the image data to an upper adjacent pixel,
a down control signal (M_DN) for moving the image data to a lower adjacent pixel,
a left control signal (M_LE) for moving the image data to a left adjacent pixel, and
a right control signal (M_RI) for moving the image data to a right adjacent pixel.

11. The pixel of the display apparatus according to claim 10,
wherein the first path controller is configured to select:
a connection path with a lower adjacent pixel for receiving data when the up control signal (M_UP) is received;
a connection path with an upper adjacent pixel for receiving data when the down control signal (M_DN) is received;
a connection path with a right adjacent pixel for receiving data when the left control signal (M_LE) is received; and
a connection path with a left adjacent pixel for receiving data when the right control signal (M_RI) is received.

12. The pixel of the display apparatus according to claim 10,
wherein the second path controller is configured to select:
a connection path with an upper adjacent pixel for shifting data when the up control signal (M_UP) is received;
a connection path with a lower adjacent pixel for shifting data when the down control signal (M_DN) is received;
a connection path with a left adjacent pixel for shifting data when the left control signal (M_LE) is received; and
a connection path with a right adjacent pixel for shifting data when the right control signal (M_RI) is received.

13. The pixel of the display apparatus according to claim 8,
wherein the pixel-embedded memory comprises:
a first dummy shift register configured to retrieve 1-bit data stored in the pixel-embedded memory of an adjacent pixel;
n-bit shift registers configured to store n-bit image data; and
a second dummy shift register configured to retrieve 1-bit data stored in the n-bit shift registers.

14. The pixel of the display apparatus according to claim 13,
wherein the first dummy shift register operates to retrieve 1-bit data from the pixel-embedded memory of the adjacent pixel at a first clock of the data movement time interval,
the second dummy shift register operates to retrieve 1-bit data from the n-bit shift registers at a second clock of the data movement time interval, and
each of the n-bit shift registers is configured to shift 1-bit data starting from a third clock of the data movement time interval.

15. The pixel of the display apparatus according to claim 13,
wherein the first dummy shift register and the second dummy shift register include a reset switch configured to reset the registers after the image data is moved.

16. A display apparatus comprising:
a controller configured to control data writing, light-emitting element driving, and data movement; and
a plurality of pixels each including a pixel-embedded memory configured to store image data represented by a multi-bit value,
wherein at least one of the plurality of pixels comprises:
a plurality of output pins configured to output image data stored in the pixel-embedded memory to an adjacent pixel based on a control signal input from the controller during a data movement time interval; and
a plurality of input pins configured to receive image data from an adjacent pixel.

17. The display apparatus according to claim 16,
wherein the plurality of output pins comprises:
an up output pin (DO_U) configured to output image data to an upper adjacent pixel,
a down output pin (DO_D) configured to output image data to a lower adjacent pixel,
a left output pin (DO_L) configured to output image data to a left adjacent pixel, and
a right output pin (DO_R) configured to output image data to a right adjacent pixel;
and wherein the plurality of input pins comprises:
a down input pin (DI_D) configured to receive image data from an upper adjacent pixel,
an up input pin (DI_U) configured to receive image data from a lower adjacent pixel,
a right input pin (DI_R) configured to receive image data from a left adjacent pixel, and
a left input pin (DI_L) configured to receive image data from a right adjacent pixel.

18. A display apparatus comprising:
a controller configured to control data writing, light-emitting element driving, and data movement; and
a first pixel and a second pixel,
wherein each of the first pixel and the second pixel includes a pixel-embedded memory configured to store image data represented by a multi-bit value,
and wherein the pixel-embedded memory comprises:
a first dummy shift register configured to retrieve 1-bit data stored in a pixel-embedded memory of an adjacent pixel;
n-bit shift registers configured to store n-bit image data; and
a second dummy shift register configured to retrieve 1-bit data stored in the n-bit shift registers during a data movement time interval.

19. The display apparatus according to claim 18,
wherein, when the first pixel and the second pixel are connected to a same column line,
image data shift between left and right adjacent pixels is performed over n+1 line times.

20. The display apparatus according to claim 18,
wherein the first pixel is connected to a first column line,
the second pixel is connected to a second column line, and
when image data is shifted from the first pixel to the second pixel,
the first pixel performs bit-wise shifting in the order of its first dummy shift register, second dummy shift register, and n-bit shift registers during a clock cycle of the first column line, and
the second pixel performs bit-wise shifting in the order of its first dummy shift register, second dummy shift register, and n-bit shift registers during a clock cycle of the second line that is delayed by one line time relative to the clock cycle of the first column line.
